# EUROPÄISCHE PATENTANMELDUNG

(11) **EP 4 742 017 A1**
(43) Veröffentlichungstag der Anmeldung: **13.05.2026**
(21) Anmeldenummer: 25211190.1
(22) Anmeldetag: 24.10.2025
(51) Int. Cl.: G06F 3/04817, G06F 3/044, G06F 1/16, G06F 3/03, G06F 3/038, H03K 17/96, G06F 3/02, G06F 3/041, G06F 3/048

(54) **TASTENMODUL FÜR PANEL-PCS UND EINE DARAUS GEBILDETE TASTENMODUL-PANEL-PC-EINHEIT**

(30) Priorität: 06.11.2024 DE 202024106341 U
(71) Anmelder: GETT Gerätetechnik GmbH, 08233 Treuen (DE)
(72) Erfinder: sachs, Andre, 08223 Falkenstein (DE); Zeeh, Andreas, 08223 Neustadt (DE); Kieselbach, Jens, 08412 Werdau (DE); Klonovsky, Alexander, 08280 Aue-Bad Schlema (DE)
(74) Vertreter: Helge, Reiner

(57) **Zusammenfassung**

Tastenmodul für Panel-PCs, die eine berührungsempfindliche Displayvorrichtung mit einer Anzeigeeinheit, die durch einen Controller steuerbar ist und eine zusammenhängende Anzeigefläche zur Darstellung von Pixelgraphik umfasst, die Displayvorrichtung und der dazugehörige Controller in einem Displaygehäuse, das als Rahmen und /oder abdeckendes Gehäuse ein- oder mehrteilig ausgebildet ist, angeordnet ist, dadurch gekennzeichnet, dass das Displaygehäuse des Panel-PC (4) mit einem extern anpassbaren, beleuchtete kapazitive Touch-Display-Einheiten (9) aufweisenden Tastenmodul (1) koppelbar ist, wobei das Tastenmodul (1) einen eigenständigen Controller (10) aufweist, der mit den kapazitiven Touch-Display- Einheiten (9) verbunden ist und die Touch-Display-Einheiten (9) auf der Unterseite der Glas-Abdeckung (Front) angeordnet sind.

## Beschreibung

Das Gebrauchsmuster bezieht sich auf das technische Gebiet großformatiger Panel-PCs, insbesondere mit einer integrierte Touch-Struktur für den Einsatz an Maschinen und Anlagen zur Prozessvisualisierung. Als Panel-PC oder auch Touch Panel-PC werden Arten von Industrie-PCs bezeichnet, bei denen der PC und das Display in einem Gehäuse vereint sind. Typische Einsatzgebiete dieser Panel-PCs sind die Fertigungs- und Prozessautomatisierung, die Maschinensteuerung und als Anzeige- und Bediengerät. Der Vorteil des Touch Panel-PC gegenüber einem klassischen Industrie-PC ist der geringe Verkabelungs- und Montageaufwand, der geringere Platzbedarf und oftmals auch die günstigeren Gesamtkosten.

Touchscreen oder Touch-panels sind sensorartige Anzeigegeräte, die Eingabesignale wie Kontakte empfangen können. Wenn die grafischen Tasten auf dem Bildschirm berührt werden, kann das Feedbacksystem auf dem Bildschirm verschiedene Verbindungsgeräte gemäß vorprogrammierten Programmen ansteuern, wodurch das mechanische Tastenfeld ersetzt und über den Bildschirm lebendige Audio- und Videoeffekte erzeugt werden können. Als intelligentes Schnittstellenprodukt für die Mensch-Computer-Interaktion sind Touchscreens in der Produktion und im Alltag weit verbreitet. In der bestehenden Technologie verwenden Touchscreens im Allgemeinen eine doppelschichtige Dünnschichtstruktur.

Mit der Entwicklung der automatisierten Fertigungstechnik findet der Industrie-Tablet-PC (industrial flat panel - IFP) immer mehr Anwendung. Durch den Anschluss über die Übertragungsschnittstelle am Gerät können verschiedene Anwendungen realisiert werden. Im Unterschied zu gewöhnlichen Computergeräten arbeiten IFPs häufig mit automatisierten Fertigungsanlagen, deren Arbeitsumgebung sehr komplex ist.

Aus dem DE 20 2015 104 887 U1 ist allgemein die Eingabe bzw. Bedienung an einem Multifunktionsterminal mit einem rechnergestützten Anzeigegerät bekannt und betrifft insbesondere eine Vorrichtung zur sicherheitsrelevanten Bedienung bzw. Eingabe an einem kombinierten Anzeige- und Eingabegerät, nämlich einem MFT mit Softkey-Tastenanordnung und einem Anzeigegerät zur Erzeugung von Pixelgrafik. Das Multifunktionsterminal zur sicheren Bedienung umfasst eine Anzeigevorrichtung mit einer Rechnereinheit zur Erzeugung von Pixelgrafik und einem Bildschirm zu deren Darstellung; eine Bilddatenleitung von der Rechnereinheit zum Bildschirm; eine Softkey-Tastenanordnung mit mehreren Tasten außerhalb des Bildschirms zur Erfassung von Eingaben, wobei die Funktion einer Taste jeweils mit Änderung der Bilddarstellung in einem der Taste zugeordneten Bereich dynamisch durch die Rechnereinheit angepasst werden kann. Als Anzeigegerät kommt dabei jedes pixelbasierte Display, aber insbesondere ein TFT-Panel in Betracht, bei denen die Tasten als reihenförmige Folientasturen ausgebildet sind.

Aus dem DE 20 2010 013 907 U1 ist ein Anzeigeelement und eine Anzeigevorrichtung zur Bereitstellung eines für einen Benutzer auswählbaren und/oder verwendbaren Inhalts, z. B. (Auswahl-)Werkzeuge/(Auswahl-)Menüs, eines Anzeigeelements z. B. Icon bzw. Symbol, für eine Anzeigevorrichtung z. B. eines Bildschirms bzw. Monitors, auf der mindestens ein Anzeigefeld darstellbar ist bzw. dargestellt wird, bekannt.

Die DE 11 2012 006 877 T5 betrifft eine Informationsvorrichtung, deren Bedienung durch ihre Verbindung mit externer Ausrüstung über eine kabelgebundene oder kabellose Verbindung durchgeführt wird, wobei die Informationsvorrichtung eine Flüssigkristallanzeigeneinheit; ein Touch-Panel, das auf der Anzeigenoberfläche der Flüssigkristallanzeigeneinheit montiert ist, eine Berührungsbedienfläche breiter als die Anzeigenfläche der Flüssigkristallanzeigeneinheit und das einen spezifischen Bedienhandhabungsabschnitt aufweist, der auf einer Fläche entsprechend einer Außer-Anzeigenfläche der Berührbedienfläche ausgebildet ist und der eine Bedienung für ein spezifisches Bedienelement einer Informationsvorrichtung akzeptiert; eine Steuerung, die das Steuern in einer Weise ausführt, welche den spezifischen Bedienhandhabungsabschnitt veranlasst, eine Bedienung entsprechend einem spezifischen Bedienelement von externer Ausrüstung zu akzeptieren, beinhaltet.

Aus dem DE 20 2018 105 302 U1 ist ein Multifunktionsterminal bekannt, umfassend eine berührungsempfindliche Displayvorrichtung, mit einer Anzeigeeinheit, insbesondere einem TFT-Panel, die durch eine Rechnereinheit steuerbar ist und eine zusammenhängende Anzeigefläche zur Darstellung von Pixelgrafik aufweist; und mit einer an der Anzeigeeinheit angeordneten Erfassungseinheit, insbesondere einer Touch-Sensoreinheit, zur Positionserfassung von Eingaben innerhalb einer zusammenhängenden Eingabefläche sowie eine intransparente Blendmaske über der Displayvorrichtung, welche einen ersten Bereich mit einem transparenten Hauptfenster zur Darstellung von Pixelgrafik und/oder für positionsabhängige Eingaben sowie mindestens einen zweiten Bereich mit mehreren getrennten Nebenfenstern aufweist, wobei sowohl das Hauptfenster als auch die Nebenfenster die Anzeigefläche und die Eingabefläche überschneiden.

Aus der US 5,594,471 A ist bekannt, dass die Erfassungseinheit, z.B. eine Touch-Sensoreinheit, zur Positionserfassung von Eingaben, mit einer zusammenhängenden Eingabefläche ausgeführt ist, die größer ist als die wirksame Anzeigefläche der Anzeigeeinheit. Somit kann der über die Anzeigefläche überstehende Flächenbereich der Erfassungseinheit für die Erfassung an getrennten Tasten genutzt werden. Die getrennten Tasten sind dabei durch Tastenbereiche in einer abdeckenden Schablone (engl. template) über der Vorrichtung gebildet. Eine Pixelgrafik innerhalb der Tastenfenster ist hierbei nicht möglich.

Die EP 2 687 972 A2 beschreibt Techniken für programmierbare Tasten auf der Blende eines mobilen Endgerätes. Es werden ein Terminal und ein Verfahren für eine programmierbare Taste auf einer Blende des Terminals bereitgestellt. Für ein mobiles Terminal, das einen Berührungssensor, ein erstes Display und mindestens ein zweites Display umfasst, das an der Blende angeordnet ist, wobei die Blende das erste Display zumindest teilweise umgibt, umfasst das Verfahren das Zuordnen eines auf dem ersten Display angezeigten Objekts zu einer Taste auf dem mindestens einen zweiten Display, das Anzeigen der Taste auf dem mindestens einen zweiten Display und das Ausführen einer dem Objekt entsprechenden Aktion, wenn die angezeigte Taste betätigt wird.

Bei dem bekannten Stand der Technik kann die Benutzerführung durch Anzeigen von Icons erleichtert werden. Von Nachteil ist, das weniger Icons der Funktionalität eines Systems unerwünschte Grenzen setzen. Um die Anzahl gleichzeitig angezeigter Icons für eine gegebene Anzeigevorrichtung zu erhöhen, müsste die Icon-Größe jedoch reduziert werden, was die Benutzerführung erschwert und leicht zu Eingabefehlern führt.

Ein weiterer großer Nachteil ist, dass die Tastenbeschriftung der Icons (einer aktuell angezeigten Taste) derzeit aufgedruckt ist und eine Änderung nicht möglich ist. Das bedeutet, dass bei der Herstellung der Berührungsbildschirm-Anzeigegeräte die Beschriftung der Icons bekannt sein muss und somit für jedes Tastenlayout eine Lagerhaltung nötig ist.

Eine erste Aufgabe der vorliegenden Erfindung besteht darin, Panel-PCs mit externen Tastenleiste bereitzustellen, die die vorbekannten Nachteile beseitigen, Änderungen der Tastenbedeutung je nach Applikation möglich machen, wobei der Anwender beim Einsatz von Tastenleisten für Panel-PCs über den Tasteninhalt anhand von Icons bestimmen kann und wodurch eine größere Flexibilität bei der Anwendung in einem breiten Spektrum von hergestellten Panel-PCs ermöglicht wird. Eine weitere, unabhängige Aufgabe der Erfindung ist es, aus einem Panel-PC und einem externen Tastenmodul eine Einheit zu schaffen.

Die Aufgabe wird durch die Merkmale der unabhängigen Ansprüche gelöst. Vorteilhafte Ausgestaltungen der Erfindung sind Gegenstand der abhängigen Ansprüche oder lassen sich aus der nachfolgenden Beschreibung sowie den Ausführungsbeispielen entnehmen.

Das erfindungsgemäße externe Tastenmodul ist koppelbar mit einem Panel-PC, der eine berührungsempfindliche Displayvorrichtung mit einer Anzeigeeinheit, die durch einen Controller steuerbar ist und eine zusammenhängende Anzeigefläche zur Darstellung von Pixelgraphik enthält, umfasst. Die Displayvorrichtung und der dazugehörige Controller des Panel-PC sind in einen Displaygehäuse, das als Rahmen und/oder abdeckendes Gehäuse ein- oder mehrteilig ausgebildet ist, angeordnet, wobei der Panel-PC mit dem externen anpassbaren, beleuchtete kapazitive Touch-Display-Einheit aufweisenden Tastenmodul koppelbar ist.

Das Tastenmodul weist einen eigenständigen Controller auf, der mit den kapazitiven Touch-Display-Einheiten verbunden ist. Die Displays, beispielsweise Displays mit Touch oder Displays und separate Touchfunktion über flächigen Touchsensor, sind auf der Unterseite der transparenten Abdeckung (Front) angeordnet. Auf der Abdeckung (Front) sind Rahmen aufgedruckt, wobei die aufgedruckten Rahmen für die Icons ein- oder mehrreihig angeordnet sind. Innerhalb der Rahmen können die Icons angezeigt werden.

Innerhalb des Controllers ist ein Speicher mit vorgegebenen Icons vorgesehen. Weitere Icons können separat erstellt werden und in den Speicher eingelesen werden. Über den Controller werden die Displays der Touch-Display-Einheiten angesteuert und die Icons innerhalb des aufgedruckten Rahmens dargestellt.

Das Tastenmodul besitzt ein oder mehrere Schnittstellen, beispielsweise USB-Befehlsschnittstellen bidirektional, Schaltausgänge, Kommunikationsschnittstellen usw.
Weiterhin ist das Gehäuse mit Anschlüssen für die Stromversorgung, USB-Anschlusses, mit Anschlüssen für einen weiteren Monitor, Ethernet und / oder seriellen Ausgängen versehen.

Gekoppelt werden Panel-PC und Tastenmodul beispielsweise durch Anstecken über die Verbindungsstifte, wobei eine elektrische Verbindung durch das USB-Kabel hergestellt werden kann.

Anderseits ist es auch möglich, das Tastenmodul auch ohne Verwendung der Verbindungsstifte mit dem Panel-PC zu koppeln, indem beide in ein externes Gehäuse eingebaut werden.

Weiterhin ist es auch möglich, das Tastenmodul als abnehmbares Tastenmodul zu verwenden, wobei die Kopplung von Panel-PC und Tastenmodul kabellos erfolgt.

Weitere Einzelheiten und Merkmale der Erfindung können den nachfolgenden Ausführungsbeispiel entnommen werden, in dem ein bevorzugtes Ausführungsbeispiels der erfindungsgemäßen Tastenmoduls erläutert ist. Es zeigen:
Fig. 1: eine Frontansicht des erfindungsgemäßen Tastenmoduls
Fig. 2: Prinzipdarstellung des Aufbaus des Tastenmoduls
Fig. 3: eine schematische Prinzipdarstellung der Kopplung von Tastenmodul und Panel-PC

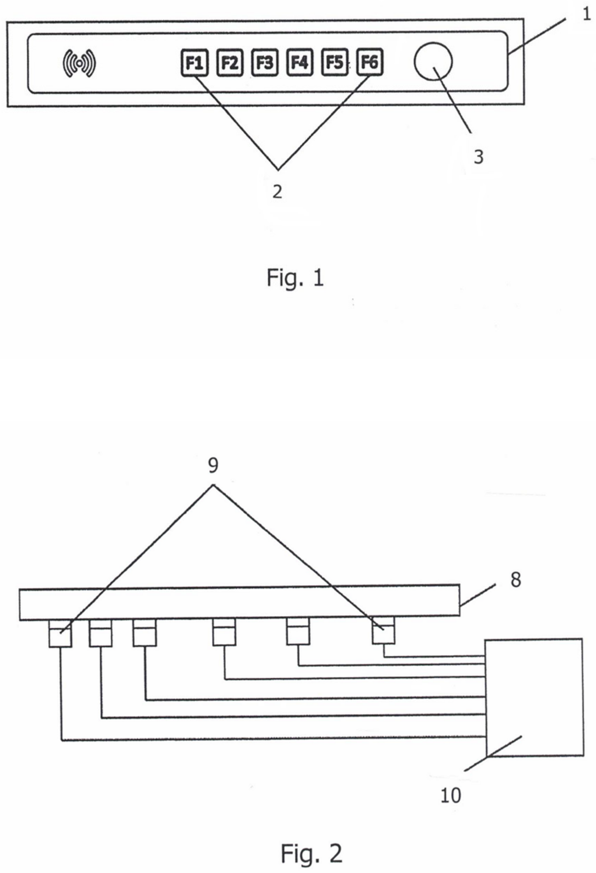

Die Figur 1 zeigt die Frontansicht des Tastenmoduls 1. Das Tastenmodul 1 umfasst im Wesentlichen ein Gehäuse mit einer transparenten Abdeckung, vorzugsweise einer GlasAbdeckplatte, die von einem intransparenten Rahmen umgeben oder auf diesem sitzt ist. Auf der Abdeckplatte sind die Rahmen für die Icons 2 aufgedruckt. Weiterhin nimmt die Abdeckplatte weitere Bedienelemente, z.B. einen Not-Aus-Taster 3, auf.

Die Figur 2 zeigt eine Prinzipdarstellung des inneren Aufbaus des Tastenmoduls 1. Auf der als Front 8 bezeichneten Abdeckplatte sind auf der Unterseite die Touch-Display-Einheiten aufgebracht und bilden das Bedienfeld.

Die Touch-Display-Einheiten 9 sind als kapazitive Tasten ausgebildet und mit einer Auswerteeinheit des Controllers 10 verbunden. Die kapazitiven Tasten weisen jeweils innerhalb des aufgedruckten Rahmens oder auch flächig für die Icons 2 eine zur Berührung durch einen Nutzer vorgesehene Sensoroberfläche auf.

Innerhalb des Controllers 10 ist ein Speicher zur Auswahl fertiger Icons 2 vorgesehen. Mit einem Editor zur Erstellung von Icons 2 können am PC weitere Icons erzeugt und eingespielt werden. Dadurch ist es möglich, die Icons 2 innerhalb des aufgedruckten Rahmens auf der Front 8 bzw. der transparenten Abdeckung je nach Bedarf zur Anzeige zu bringen. Die Anzeige erfolgt über die Displays der Touch-Displays 9. Ein Bildwechsel der Icons 2 ist zu jeder Zeit möglich.

Das Tastenmodul 1 besitzt eine oder mehrere Schnittstellen, z.B. USB-Befehlsschnittstellen bidirektional, Schaltausgänge, Kommunikationsschnittstellen usw. Weiterhin ist das Gehäuse des Tastenmoduls 1 mit Anschlüssen für die Spannungsversorgung, USB-Anschlüssen, mit Anschlüssen für eine weiteren Monitor, Ethernet und/ oder seriellen Ausgängen versehen.

Der Vorteil dieser Ausführung ist, dass die Icons 2 der Tasten nicht mehr aufgedruckt werden müssen, sondern werden durch die auf der Unterseite der Front 8 bzw. der Abdeckplatte angebrachten Displays der Touch-Displays-Einheit 9 innerhalb des Rahmens angezeigt. Dadurch ist jederzeit möglich die Icons 2 innerhalb der aufgedruckten Rahmen den Anforderungen für den Einsatz an Maschinen und Anlagen zur Prozessdatenvisualisierung anzupassen.

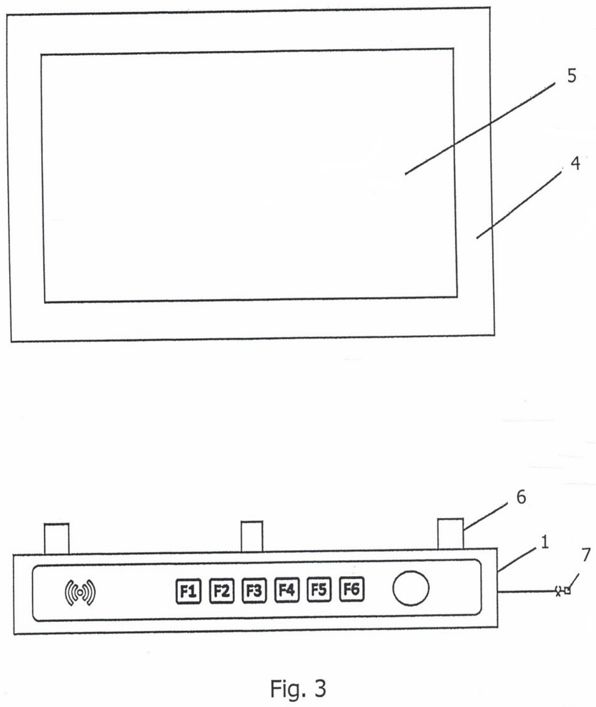

Die Figur 3 zeigt schematisch die Kopplung des Tastenmoduls 1 mit einen Panel-PC 4. Das Panel-PC 4 umfasst im Wesentlichen ein Gehäuse mit einem Display 5, das von einem intransparenten Rahmen umgeben ist oder auf diesem sitzt. Der Panel-PC 4 ist z.B. ein sogenannter Industrie-PC für den Einsatz an Maschinen und Anlagen zur Prozessdatenvisualisierung und baut beispielsweise auf einer x86 Controllerbasis auf. Damit stehen dem Anwender eine Vielzahl von Applikationen zur Verfügung.

Der Panel-PC 4 wird in verschiedenen Größen ausgeführt und basiert auf einem modularen Konzept. Das Gehäuse ist als robustes lüfterloses Metallgehäuse ausgeführt und damit auch für den Einsatz in einer rauhen Umgebung geeignet. Der große kapazitive Touchscreen (Display 5) ermöglicht eine zeitgemäße Bedienung.

Gekoppelt ist der Panel-PC 4 mit dem externen Tastenmodul 1 durch Anstecken über die Verbindungsstifte 6. Elektrisch verbunden werden Panel-PC 4 und Tastenmodul 1 beispielsweise über USB-Kabel 7.

Die Einheit von Panel-PC 4 und Tastenmodul 1 kann als eigenständige Einheit als Industrie-PC betrieben oder mittels Standardschnittstellen in ihre Infrastruktur eingebunden werden. Optional ist es möglich den Industrie-PC nebst Touchscreen auch mit dem Tastenmodul in einem WLAN-Netzwerk oder auch mit einem zweiten Display zu betreiben.

Die Einsatzgebiete sind vielfältig und reichen über Produktion, Labor, Lager usw. um dort Aufgaben wie Steuerung, Erfassung, Visualisierung und ähnliches zu übernehmen.

### Bezugszeichenaufstellung:

1 - Tastenmodul
2 - Icons
3 - Not-Aus-Taster
4 - Panel-PC
5 - Display
6 - Verbindungsstifte
7 - USB-Kabel
8 - Front
9 - Touch-Display-Einheit
10 - Controller

## Patentansprüche

1. Tastenmodul für Panel-PCs, die eine berührungsempfindliche Displayvorrichtung mit einer Anzeigeeinheit, die durch einen Controller steuerbar ist und eine zusammenhängende Anzeigefläche zur Darstellung von Pixelgraphik umfasst, die Displayvorrichtung und der dazugehörige Controller in einem Displaygehäuse, das als Rahmen und /oder abdeckendes Gehäuse ein- oder mehrteilig ausgebildet ist, angeordnet ist, **dadurch gekennzeichnet, dass** das Displaygehäuse des Panel-PC (4) mit einem extern anpassbaren, beleuchtete kapazitive Touch-Display-Einheiten (9) aufweisenden Tastenmodul (1) koppelbar ist, wobei das Tastenmodul (1) einen eigenständigen Controller (10) aufweist, der mit den kapazitiven Touch-Display- Einheiten (9) verbunden ist und die Touch-Display-Einheiten (9) auf der Unterseite der Glas-Abdeckung (Front) angeordnet sind.

2. Tastenmodul nach Anspruch 1, **dadurch gekennzeichnet, dass** innerhalb des Controllers (10) ein Speicher mit vorgegebenen oder über einen externen Editor erweiterbaren Icons (2) vorgesehen ist und über den Controller (10) die Displays der Touch-Display-Einheiten (9) ansteuerbar und die Icons (2) innerhalb des aufgedruckten Rahmens darstellbar sind.

3. Tastenmodul nach Anspruch 1 und 2, **dadurch gekennzeichnet, dass** die Oberfläche des Tastenmoduls (1) aus einer transparenten Abdeckung (Front 8) gebildet wird, auf der der Rahmen für die Icons (2) aufgedruckt sind.

4. Tastenmodul nach Anspruch 1 bis 3, **dadurch gekennzeichnet, dass** die auf die transparente Abdeckung (Front 8) aufgedruckten Rahmen für die Icons (2) ein- oder mehrreihig angeordnet sind.

5. Tastenmodul nach Anspruch 1 bis 4, **dadurch gekennzeichnet, dass** die als Front 8 bezeichnete transparente Abdeckung mit den auf der Unterseite angebrachten Touch-Display Einheiten (9) das Bedienfeld des Tastenmoduls (1) bildet.

6. Tastenmodul nach Anspruch 1, **dadurch gekennzeichnet, dass** das Tastenmodul (1) eine oder mehrere Schnittstellen aufweist, über die das Tastenmodul (1) mit dem Panel-PC (4) oder mit externen Geräten elektrisch verbindbar ist

7. Tastenmodul-Panel-PC-Einheit unter Verwendung eines Tastenmodul nach Anspruch 1 und mindestens einem der Ansprüche 2 bis 6, **dadurch gekennzeichnet, dass** Panel-PC (4) und Tastenmodul (1) mittels Verbindungsstifte (6) untereinander koppelbar sind, wobei eine elektrische Verbindung durch das USB-Kabel (7) herstellbar ist.

8. Tastenmodul-Panel-PC-Einheit unter Verwendung eines Tastenmodul nach Anspruch 1 und mindestens einem der Ansprüche 2 bis 6, **dadurch gekennzeichnet, dass** Panel-PC (4) und Tastenmodul (1) durch Einbau in ein externes Gehäuse gekoppelt sind.

9. Tastenmodul-Panel-PC-Einheit unter Verwendung eines Tastenmodul nach Anspruch 1 und mindestens einem der Ansprüche 2 bis 6, **dadurch gekennzeichnet, dass** Tastenmodul (1) innerhalb der Tastenmodul-Panel-PC-Einheit als abnehmbares Tastenmodul ausgebildet ist, wobei die Kopplung von Panel-PC und Tastenmodul kabellos erfolgt.
